**Europäisches Patentamt**

(19) **European Patent Office**

**Office européen des brevets**

(11) Veröffentlichungsnummer : **0 217 122 B1**

(12) **EUROPÄISCHE PATENTSCHRIFT**

(45) Veröffentlichungstag der Patentschrift :
**05.06.91 Patentblatt 91/23**

(51) Int. Cl.⁵ : **H03K 5/13**

(21) Anmeldenummer : **86111744.8**

(22) Anmeldetag : **25.08.86**

(54) **Schaltungsanordung mit einer matrixförmigen Speicheranordnung zur variabel einstellbaren Verzögerung digitaler Signale.**

(30) Priorität : **04.09.85 DE 3531598**

(43) Veröffentlichungstag der Anmeldung :
**08.04.87 Patentblatt 87/15**

(45) Bekanntmachung des Hinweises auf die
Patenterteilung :
**05.06.91 Patentblatt 91/23**

(84) Benannte Vertragsstaaten :
**AT BE DE FR GB IT NL SE**

(56) Entgegenhaltungen :
**EP-A- 0 031 950**
**EP-A- 0 193 157**

(56) Entgegenhaltungen :
**US-A- 3 893 088**
**US-A- 4 426 685**
**IBM TECHNICAL DISCLOSURE BULLETIN,
Band 25, Nr. 9, Februar 1983, Seiten 4858-4859,
New York, US; W.B. CHIN et al.: "Static latch
with inverted output device"**
**PATENT ABSTRACTS OF JAPAN, Band 8, Nr.
70 (E-235)[1507], 3. April 1984 & JP-A-58-218
229**

(73) Patentinhaber : **Siemens Aktiengesellschaft
Wittelsbacherplatz 2
W-8000 München 2 (DE)**

(72) Erfinder : **Mattausch, Hans Jürgen, Dr.
Am Brunnen 25
W-8011 Kirchheim (DE)**

## Beschreibung

Die vorliegende Erfindung betrifft eine Schaltungsanordnung mit einer matrixförmigen Speicheranordnung zur variabel einstellbaren Verzögerung digitaler Signale, bei der ein von einem Eingangsdatentakt taktgesteuerter, kontinuierlich fortschaltbarer Zeilenwähler vorgesehen ist, der je zwei in der Phase gegeneinander versetzte Signalausgänge je Wählschritt aufweist, die jeweils eine von Schreibwortleitungen bzw. von Lesewortleitungen ansteuern, welche je Zeile der Matrix vorgesehen sind, wobei je Spalte zwei getrennte Bitleitungen, nämlich eine von Schreibbitleitungen und eine von Lesebitleitungen, vorgesehen sind, die jeweils mit allen Speicherzellen einer Spalte zusammengeschaltet sind, wobei je Spalte ein abtrennbarer, speichernder Verstärker vorgesehen ist, dessen Eingang mit der Lesebitleitung der ihm zugeordneten Spalte und dessen Ausgang mit der Schreibbitleitung der ihm nachgeordneten Spalte verbunden ist, und wobei die Speicheranordnung einen Dateneingang aufweist, über den die zu verzögernden Datensignale eingebbar sind.

Auf dem Gebiet der digitalen Signalverarbeitung sowie auf dem Gebiet der Nachrichtentechnik werden vielfach Einrichtungen benötigt, mit deren Hilfe definierte Verzögerungen von digitalen Datenströmen bewirkt werden können. Definierte Verzögerungen werden beispielsweise zum Ausgleich von Laufzeiten verwendet. Bei einer konstanten Anzahl von gewünschten Verzögerungstakten bietet sich im allgemeinen als Verzögerungseinrichtung eine Anordnung mit einem Schieberegister an. Soll jedoch die Verzögerung variabel einstellbar sein, so ergeben sich bei Verwendung von Schieberegistern bestimmte Probleme.

Es ist auch bekannt, Datenströme definiert mittels einer Anordnung aus Standardschaltungen und Speicherbausteinen zu verzögern. In einer derartigen Anordnung werden die Bestandteile des Datenstromes in einem frei adressierbaren Speicher abgelegt. Dieser Speicher wird durch einen Decoder angesteuert, der seinerseits durch einen (oder mehrere) Zähler angesteuert wird. Dabei wird die Dauer der Verzögerung durch den Abstand der Zähler-Rücksetzimpulse gegeben. Da in die Speicherzellen derartiger frei adressierbarer Speicher je Takt nur jeweils eingeschrieben oder aus diesen ausgelesen werden kann, ergibt sich dabei die Notwendigkeit, entweder die Speicher mit der doppelten Taktrate zu betreiben oder zwischen zwei Speichereinheiten in einem Multiplex-Betrieb hin- und herzuschalten. Die erste Lösung dieses Problems hat den Nachteil, daß die maximale Datentaktfrequenz nur halb so groß wie die maximale Speicherzyklusfrequenz sein darf. Die Lösung des letzteren Problems erfordert aufwendige Logikschaltungen zur Adreßsteuerung und einer erforderlichen Umordnung der Daten. Für eine integrierbare Realisierung einer derartigen Schaltungsanordnung entstehen außerdem Nachteile wegen des hohen Platzbedarfs der notwendigen Multiplexer und wegen der erforderlichen umfangreichen Verdrahtung.

Gemäß EP-A-0 193 157 (Stand der Technik gemäß Artikel 54 (3) EPÜ) ist bereits eine Schaltungsanordnung mit einer matrixförmigen Speicheranordnung zur variabel einstellbaren Verzögerung digitaler Signale vorgeschlagen worden. Diese bekannte Schaltungsanordnung mit einer matrixförmigen Speicheranordnung zur variabel einstellbaren Verzögerung digitaler Signale enthält im wesentlichen als speichernde Elemente an sich bekannte 3-Transistorzellen mit überlappenden Schreib Lese/-Zyklen und einem von einem Eingangsdatentakt taktgesteuerten, kontinuierlich fortschaltbaren, jederzeit rücksetzbaren Zeilenwähler, der je zwei in der Phase gegeneinander versetzte Signalausgänge je Wählschritt aufweist, die jeweils eine Schreibwortleitung bzw. eine Lesewortleitung ansteuern. Der Zeilenwähler dieser bekannten Schaltungsanordnung wird mit einem vorzugsweise aus dem Eingangsdatentakt ableitbaren Reset-Signal rückgesetzt. Der zeitliche Abstand zwischen Rücksetzimpulsen wird derart gewählt, daß er gleich der geforderten Verzögerungszeit ist, welche zwischen einem unverzögerten Datenausgang und dem ersten aus m verzögerten Datenausgängen eingestellt werden soll.

Aus der US-A-3 893 088 ist bereits eine Schaltungsanordnung nach dem Oberbegriff des Anspruchs 1 mit einer matrixförmigen Speicheranordnung zur variablen einstellbaren Verzögerung digitaler Signale bekannt, bei der ein von einem Eingangsdatentakt taktgesteuerter, kontinuierlich fortschaltbarer Zeilenwähler vorgesehen ist, der je zwei in der Phase gegeneinander versetzte Signalausgänge je Wählschritt aufweist, die jeweils eine von Schreibwortleitungen bzw. von Lesewortleitungen ansteuern, welche je Zeile der Matrix vorgesehen sind. Diese bekannte Anordnung weist je Spalte der Matrix zwei getrennte Bitleitungen, nämlich eine der Schreibbitleitungen und eine der Lesebitleitungen auf, die jeweils mit allen Speicherzellen einer Spalte zusammengeschaltet sind. Je Spalte kann ein abtrennbarer, speichernder Verstärker vorgesehen sein, dessen Eingang mit der Lesebitleitung der ihm zugeordneten Spalte und dessen Ausgang mit der Schreibbitleitung der ihm nachgeordneten Spalte verbunden ist. Die Speicheranordnung weist einen Dateneingang auf, über den die zu verzögernden Datensignale eingebbar sind.

Aus der Druckschrift "IBM-Technical Disclosure Bulletin, Vol. 25, No. 9, Feb. 1983, Seiten 4858 u. 4859 ist eine Speicherzelle für eine matrixförmige Speicheranordnung bekannt, die als speicherndes Element ein Kippglied in Form von zwei miteinander rückgekoppelten Invertern aufweist, von dessen zwei Knoten der eine über einen von einer Schreibwortleitung her steuerbaren Schalttransistor mit einer Schreibbitleitung und der andere über einen von einer Lesewortleitung her steuerbaren Schalttransistor mit einer Lesebitleitung verbind-

2

EP 0 217 122 B1

bar ist.

Der Druckschrift EP-A-0 031 950 ist eine Anregung zu einer Auswahleinrichtung entnehmbar, durch die die Länge der Schieberegisterstrecke verändert wird, was bei einer matrixförmigen Speicheranordnung der Auswahl der Spalte für das Ausgangssignal entspricht.

Der vorliegenden Erfindung liegt die Aufgabe zugrunde, eine Schaltungsanordnung der eingangs genannten Art zu schaffen, mittels derer definierte, freizügig einstellbare Verzögerungen erzielt werden können, die als integrierte Schaltungsanordnung realisierbar ist, einen geringen Flächenbedarf hat und gegenüber dem vorbekannten Stand der Technik höhere Datenraten zuläßt. Insbesondere besteht die Aufgabe darin, eine Schaltungsanordnung zu schaffen, die für eine Integration in MOS-Technik besonders geeignet ist.

Die genannte Aufgabe für die vorliegende Erfindung wird durch eine Schaltungsanordnung der eingangs genannten Art gelöst, die durch die in dem kennzeichnenden Teil des Patentanspruchs 1 angegebenen Merkmale charakterisiert ist.

Vorteilhafte Weiterbildungen der Erfindung sind durch die in den Unteransprüchen angegebenen Merkmale gekennzeichnet.

Im folgenden wird die vorliegende Erfindung anhand mehrerer Figuren im einzelnen erläutert.

Fig. 1 zeigt ein Blockschaltbild einer Schaltungsanordnung gemäß EP-A 0 193 157, bei der ein Zeilenwähler, eine matrixförmige Speicheranordnung, Regeneratorschaltungen sowie eine Taktsteuerung vorgesehen sind.

Fig. 2 zeigt ein Impuls/Zeit-Diagramm zur Erläuterung der Arbeitsweise der Schaltungsanordnung gemäß Fig. 1.

Fig. 3 zeigt ein Blockschaltbild für eine Schaltungsanordnung gemäß einem bevorzugten Ausführungsbeispiel für die vorliegende Erfindung.

Fig. 4 zeigt ein Schaltbild für eine Einzelheit der erfindungsgemäßen Schaltungsanordnung.

Fig. 5a, Fig. 5b, Fig. 5c zeigen jeweils ein Ausführungsbeispiel für einen invertierenden Verstärker, wie er paarweise in Antiparallelschaltung gemäß einem Ausführungsbeispiel für die vorliegende Erfindung (vergl. Fig. 4) verwendet wird.

Fig. 6 zeigt die in Fig. 1 enthaltene symbolische Darstellung einer Zeilenwählerstufe sowie deren Prinzipschaltbild, welche Stufen in der Schaltungsanordnung gemäß Fig. 1 n-fach verwendet werden.

Fig. 7 zeigt die in Fig. 1 enthaltene symbolische Darstellung sowie ein Prinzipschaltbild eines Regenerators (Verstärkerschaltung), wie sie m-fach in der Schaltungsanordnung gemäß Fig. 1 verwendet wird.

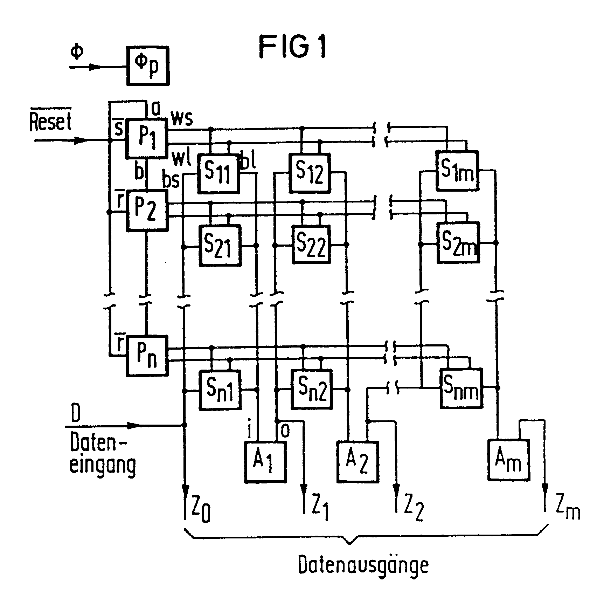

Wie bereits erläutert, zeigt Fig. 1 eine bekannte Schalungsanordnung zur variabel einstellbaren Verzögerung digitaler Signale mit einer matrixförmigen Speicheranordnung.

Die gezeigte Schaltungsanordnung enthält einen Dateneingang D, einen Rücksetzeingang $\overline{\text{Reset}}$, einen Takteingang $\emptyset$, der eine Taktsteuerung $\emptyset_P$ synchronisiert, sowie mehrere Datenausgänge $Z_0...Z_m$. Außerdem ist eine Zeilenwähler mit Stufen $P_1...P_n$ vorgesehen, bei dem die Stufen in einer Reihe zusammengeschaltet sind, bei dem die erste Stufe $p_1$ mit einem Setzeingang $\overline{s}$ und einem Signaleingang a und die restlichen Stufen $P_2...P_n$ mit ihren jeweiligen Rücksetzeingängen $\overline{r}$ an den Rücksetzeingang $\overline{\text{Reset}}$ angeschlossen sind, bei dem jeweils ein Signalausgang b mit dem Signaleingang a der jeweils folgenden Stufe verbuden ist und bei dem jeweils je Stufe eine Schreibwortleitung ws und eine Lesewortleitung wl vorgesehen sind. Als speichernde Elemente sind in der matrixförmigen Speicheranordnung an sich bekannte 3-Transistorspeicherzellen mit überlappenden Schreib-/Lesezyklen vorgesehen. Der kontinuierlich fortschaltbare, jederzeit rücksetzbare Zeilenwähler $P_1...P_n$ wird von einem Eingangsdatentakt taktgesteuert. Er weist je Wählschritt, nämlich je Stufe, zwei in der Phase gegeneinander versetzte Signalausgänge – nämliche die Schreibwortleitung ws bzw. die Lezewortleitung wl – auf, die je Zeile der Matrix vorgesehen sind. In der Speicheranordnung sind je Spalte zwei getrennte Bitleitungen – nämlich eine Schreibbitleitung bs und eine Lesebitleitung bl – vorgesehen, die jeweils mit allen Speicherzellen einer Spalte zusammengeschaltet sind. Außerden ist je Spalte ein abtrennbarer, speichernder Verstärker $A_1...A_m$ vorgesehen, dessen Eingang i jeweils mit der betreffenden Lesebitleitung bl der ihm zugeordneten Spalte und dessen Ausgang o jeweils mit der Schreibbitleitung bs der ihm nachgeorneten Spalte verbunden ist und als den jeweiligen Verstärken zugeordnete Datenausgänge $Z_1...Z_m$ dient. Der Dateneingang D für die zu verzögernden Datensignale ist mit der Schreibbitleitung bs der ersten Spalte und einem unverzögerten Datenausgang $Z_0$ verbunden. Die weiteren Datenausgäng $Z_1...Z_m$ sind gegenüber dem unverzögerten Signalausgang $Z_0$ derart verzögert, daß der Zeitliche Abstand zwischen $\overline{\text{Rest}}$-Impulsen derart gewählt wird, daß er gleich der geforderten Verzögerungszeit ist, welche zwischen dem unverzögerten Datenausgang $Z_0$ und dem ersten verzögerten Datenausgang $Z_1$ eingestellt werden soll.

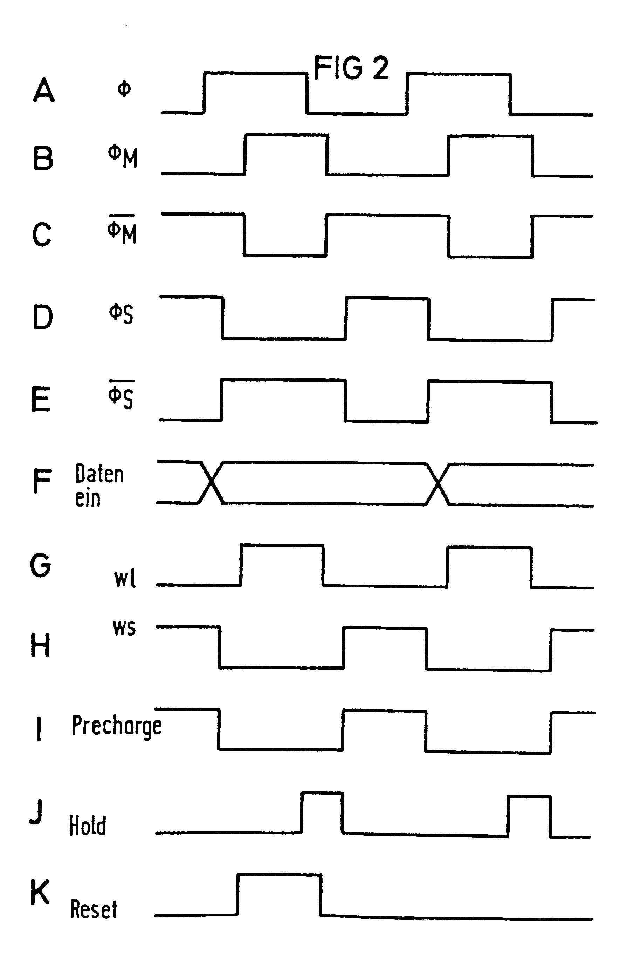

Wie bereits erläutert, zeigt Fig. 2 ein Impuls/-Zeit-Diagramm zur Erläuterung der Arbeitsweise der erfindungsgemäßen Schaltungsanordnung.

In Fig. 2A ist der an die Taktsteuerung gelegte Grundtakt $\emptyset$ dargestellt. Daraus abgeleitete Hilfstakte zur Steuerung des Zeilenwählers, nämlich $\emptyset_M$, $\overline{\emptyset_M}$, $\emptyset_S$ und $\overline{\emptyset_S}$, sind in Fig. 2B, 2C, 2D bzw. 2E gezeigt. Fig. 2F zeigt

3

die Phasenlage des Eingangsdatenstroms in bezug auf den Grundtakt ø. In Fig. 2G und Fig. 2H sind die Ausgangssignale des Zeilenwählers, nämlich das Lesewort bzw. das Schreibwortleitungssignal wl bzw. ws, dargestellt. In Fig. 2I und Fig. 2J sind ein Precharge-Signal bzw. ein Hold-Signal gezeigt, die zur Steuerung der Regeneratorschaltungen verwendet werden. Fig. 2K zeigt schließlich die Phasenlage des erforderlichen Rest-Signals in bezug auf den Grundtakt ø.

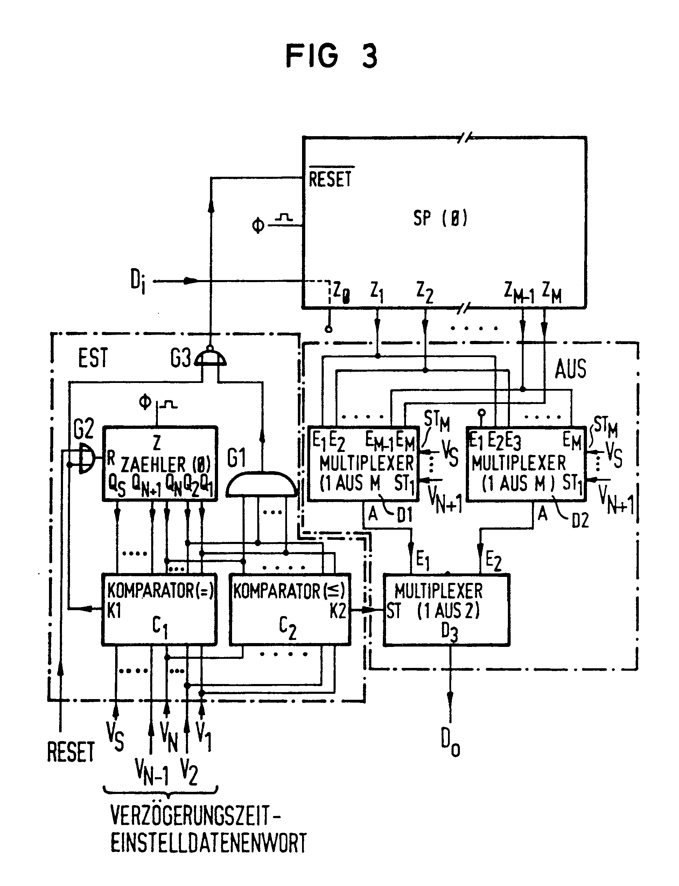

Wie bereits erläutert, zeigt Fig. 3 ein Blockschaltbild der erfindungsgemäßen Schaltungsanordnung. Diese Schaltungsanordnung weist eine matrixförmige Speicheranordnung zur variabel einstellbaren Verzögerung digitaler Signale auf. Als speichernde Elemente dieser Speicheranordnung SP sind Kippglieder in Form von zwei miteinander rückgekoppelten Invertern vorgesehen, von deren zwei Knoten der eine über einen von einer Schreibwortleitung $w_S$ her steuerbaren Schalttransistor mit einer Schreibbitleitung $b_s$ und er andere über einen von einer Lesewortleitung $w_1$ her steuerbaren Schalttransistor mit einer Lesebitleitung $b_1$ verbindbar ist. Außerdem ist ein vom Eingangsdatentakt taktgesteuerter, kontinuierlich fortschalbarer, jederzeit rücksetzbarer Zeilenwähler $P_1...P_n$ (vergl. Fig. 1) vorgesehen, der je zwei in der Phase gegeneinander versetzte Signalausgänge je Wählschritt aufweist, die jeweils eine der Schreibwortleitungen $w_S$ bzw. der Lesewortleitungen $w_1$ ansteuern, welche je Zeile der Matrix vorgesehen sind. Je Spalte dieser Matrixanordnung sind zwei getrennte Bitleitungen, nämlich eine der Schreibbitleitungen $b_s$ und eine der Lesebittleitungen $b_1$, vorgesehen, die jeweils mit allen Speicherzellen einer Spalte zusammengeschaltet sind. Je Spalte ist ein abtrennbarer, speichernder Verstärker $A_1...A_m$ vorgesehen, dessen Eingang i mit der Lesebitleitung $b_1$ der ihm zugeordneten Spalte und dessen Ausgang o mit der Schreibbitleitung $b_s$ der ihm nachgeordneten Spalte verbunden ist und als ein ihm zugeordneter Datenausgang $Z_1...Z_m$ dient. Ein Dateneingang für die zu verzögernden Datensignale ist mit der Schreibbitleitung $b_s$ der ersten Spalte verbunden. Ein Rücksetzeingang $\overline{Reset}$ ist mit Setzeingängen $\overline{s}$ eines ersten Gliedes $P_1$ des Zeilenwählers sowie mit den Rücksetzeingängen $\overline{r}$ der restlichen Glieder $P_2...P_n$ des Zeilenwählers verbunden. Eine Auswahleinrichtung AUS zum Auswählen von Spalten der Speicheranordnung SP ist darüber hinaus vorgesehen, die zwischen zwei ausgewählten benachbarten Spalten umschaltbar ist und der ein Teil eines externen Verzögerungszeit-Einstelldatenwortes zur Auswahl dieser Spalten zuführbar ist. Zum Umschalten zwischen den beiden benachbarten Spalten ist eine dynamische Umschaltung mittels eines zugeführten Steuersignals ST vorgesehen. Außerdem ist eine Einstell- und Steuereinrichtung EST vorgesehen, der das gesamte externe Verzögerungszeit-Einstelldatenwort zugeführt wird, die ein Rückstellsignal $\overline{RESET}$ für die Speicheranordnung SP und das Steuersignal ST für die Auswahleinrichtung AUS erzeugt und der ein externes Rücksetzsignal RESET über einen Rücksetzeingang zugeführt wird, welches dazu benutzt wird, die Einstell- und Steuereinrichtung EST unmittelbar und die Speicheranordnung SP mittelbar rückzustellen. Die Speicheranordnung SP weist einen Dateneingang $D_I$ auf, über den die zu verzögernden Datensignale eingebbar sind. Die Auswahleinrichtung AUS weist einen Datenausgang $D_o$ auf, über den die zu verzögernden Datensignale ausgebbar sind. Die Auswahleinrichtung AUS ist über Dateneingängen $E_1...E_M$ mit den Datenausgängen $Z_1...Z_M$ der Speicheranordnung SP verbunden. Die Einstell- und Steuereinrichtung EST ist datentaktgesteuert.

Die Auswahleinrichtung AUS besteht aus einer Anordnung aus einem ersten Multiplexer $D_1$, einem zweiten Multiplexer $D_2$ und einem dritten Multiplexer $D_3$, wobei die Datenausgänge $Z_1...Z_M$ der Speicheranordnung SP jeweils mit Dateneingängen $E_1...E_M$ des ersten Multiplexers $D_1$ und mit Dateneingängen $E_2...E_M$ des zweiten Multiplexers $D_2$ unter Versatz um eine Stelle verbunden sind, wobei der letzte Datenausgang $Z_M$ der Speicheranordnung SP nicht mit einem der Dateneingänge des zweiten Multiplexers $D_2$ verbunden ist und wobei der erste Dateneingang $E_1$ dieses zweiten Multiplexers $D_2$ frei bleibt. Für beide Multiplexer $D_1$, $D_2$ sind jeweils Wähleingänge $ST_1...ST_M$ vorgesehen, die mit dem genannten Teil des externen Verzögerungszeit-Einstelldatenwortes beaufschlagt werden und mittels derer in den Multiplexern $D_1$, $D_2$ jeweils deren Ausgang A mit einem der Dateneingänge, z.B. $E_2$, in dem ersten Multiplexer $D_1$ bzw. $E_2$ in dem zweiten Multiplexer $D_2$ verbindbar ist. Die beiden Ausgänge A, A der Multiplexer $D_1$, $D_2$ sind mit den beiden einzigen Dateneingängen $E_1$, $E_2$ des dritten Multiplexers $D_3$ verbunden, dessen Ausgang A den Datenausgang $D_o$ für die verzögerten Eingangsdaten darstellt und der einen einzigen Steuereingang ST aufweist.

Die Einstell- und Steuereinrichtung EST enthält einen Zähler Z, einen ersten Komparator $C_1$, einen zweiten Komparator $C_2$, ein UND-Glied $G_1$, ein ODER-Glied $G_2$ und ein NOR-Glied $G_3$. Der Zähler Z weist eine Anzahl von Zählschritten auf, die der Anzahl der Speicherplätze der Speicheranordnung SP entspricht. Der erste Komparator $C_1$ weist die Funktion "=" auf, wogegen der zweite Komparator $C_2$ die Funktion "$\leq$" aufweist. Die Einstell- und Steuereinrichtung EST hat eine Vielzahl von Einstelleingängen $V_1$, $V_2...V_N$, $V_{n+1}...V_S$ zum Anlegen des externen Verzögerungszeit-Einstelldatenwortes und einen Rücksetzeingang RESET, wobei die Einstelleingänge in eine erste Gruppe für die niederwertigen Bits des Verzögerungszeit-Einstelldatenwortes mit den Einstelleingängen $V_1...V_N$ und in eine zweite Gruppe für die höherwertigen Bits mit den Einstelleingängen $V_{N+1}...V_S$ unterteilt sind. Mittels der Einstelleingänge $V_1...V_N$ wird eine beliebige Zeile der Speicheranordnung SP in codierter Form gekennzeichnet, welche Kennzeichnung als ein erster Vergleichswert für den zweiten Komparator $C_2$ dient, und mittels der Einstelleingänge sowohl der ersten als auch der zweiten Gruppe wird die betreffende Zeile bzw. eine beliebige Spalte in codierter Form gekennzeichnet, welche Kennzeichnungen insgesamt als ein erster Vergleichswert für den ersten Komparator $C_1$ dienen. Der erste Komparator $C_1$ hat eine Vielzahl von Vergleichswerteingängen entsprechend Datenausgängen $Q_1...Q_N$, $Q_{N+1}...Q_S$ des Zählers Z, denen ein dem jeweiligen Zählstand des Zählers Z entsprechendes Zählstandsdatenwort zugeführt wird. Der zweite Komparator $C_2$ hat eine Anzahl von Vergleichswerteingängen entsprechend den Datenausgängen $Q_1...Q_N$ einer ersten Gruppe der Datenausgänge des Zählers Z, denen die niederwertigen Bits des dem jeweiligen Zählstand entsprechende Zählstandsdatenwortes zugeführt werden. Dem UND-Glied $G_1$ werden gleichfalls diese zuletzt genannten Bits über entsprechend viele Eingänge zugeführt. Der erste Komparator $C_1$ hat einen Vergleichsausgang $K_1$, der mit einem von zwei Eingängen des ODER-Gliedes $G_2$ und einem von zwei Eingängen des NOR-Gliedes $G_3$ verbunden ist und ein Ausgangssignal gemäß der Bedingung

$$K_1 = \{Q_1...Q_S\} = \{V_1...V_S\}$$

abgibt. Der zweite Eingang des ODER-Gliedes $G_2$ ist mit dem Rücksetzeingang der Einstell- und Steuereinrichtung EST verbunden. Der zweite Eingang des NOR-Gliedes $G_3$ ist mit dem Ausgang des UND-Gliedes $G_1$ verbunden. Der Rücksetzeingang der Speicheranordnung SP wird mit dem Ausgangssignal des NOR-Gliedes $G_3$ beaufschlagt. Ein Rücksetzeingang R des Zählers Z wird mit dem Ausgangssignal des ODER-Gliedes $G_2$ beaufschlagt. Ein Vergleichsausgang $K_2$ des zweiten Komparators $C_2$ ist mit dem Steuereingang ST des dritten Multiplexers $D_3$ verbunden. Der zweite Komparator $C_2$ gibt ein Ausgangssignal an den Vergleichsausgang $K_2$ gemäß der Bedingung

$$K_2 = \{Q_1...Q_N\} \leq \{V_1...V_N\}$$

ab, in welchem Fall der erste Dateneingang $E_1$ des dritten Multiplexers $D_3$ mit dessen Datenausgang $D_o$ verbunden ist.

Entsprechend der Wortbreite der Eingangsdaten sind eine Vielzahl von matrixförmigen Speicheranordnungen vorzusehen (nicht gezeigt), deren Schreibwort- bzw. Lesewortleitungen parallelgeschaltet und mit dem gemeinsam für diese matrixförmigen Speicheranordnungen vorgesehenen Zeilenwähler verbunden sind.

Das Reset-Signal, das dem Rücksetzeingang Reset zugeführt wird, kann gemäß einem Ausführungsbeispiel für die vorliegende Erfindung mit den Eingangssignalen bereitgestellt werden. Eine andere Lösungsmöglichkeit für die vorliegende Erfindung sieht vor, daß ein Reset-Signal intern in dem die Schaltungsanordnung aufweisenden Chip durch einen von außen einstellbaren zyklischen Zähler erzeugt wird.

Vorteilerhafterweise ist erfindungemäß vorgesehen, daß aus der Schaltungsanordnung nur diejenigen Datenausgänge herausgeführt sind, die für den jeweiligen Verwendungszweck der Schaltungsanordnung erforderlich sind.

Die Verstärker $A_1...A_m$ sind invertierend. Es ist jedoch auch möglich, die Verstärker $A_1...A_m$ nichtinvertierend auszuführen und dementsprechend jeweils einen Inverter an jedem zweiten Datenausgang $Z_1...Z_M$ der Speicheranordnung SP anzuordnen.

Der Zeilenwähler $P_1...P_N$ besteht gemäß einer anderen Weiterbildung der Erfindung aus einem Schieberegister, einem Verknüpfungsblock und zwei Ausgangstreibern mit Ausgängen $w_s$ bzw. $w_1$ je Glied des Zeilenwählers (nicht gezeigt), wobei die Phasenlagen und Impulsbreiten der Ausgangssignale an den Ausgängen $w_S$ und $w_1$ durch entsprechende Verknüpfunden dreier in dem Schrieberegister vorhandener Abgriffe bewirkt werden kann.

Vorteilhafterweise ist vorgesehen, daß die erfindugsgemäße Schaltungsanordnung als monolitisch integrierte MOS-Schaltung realisiert ist.

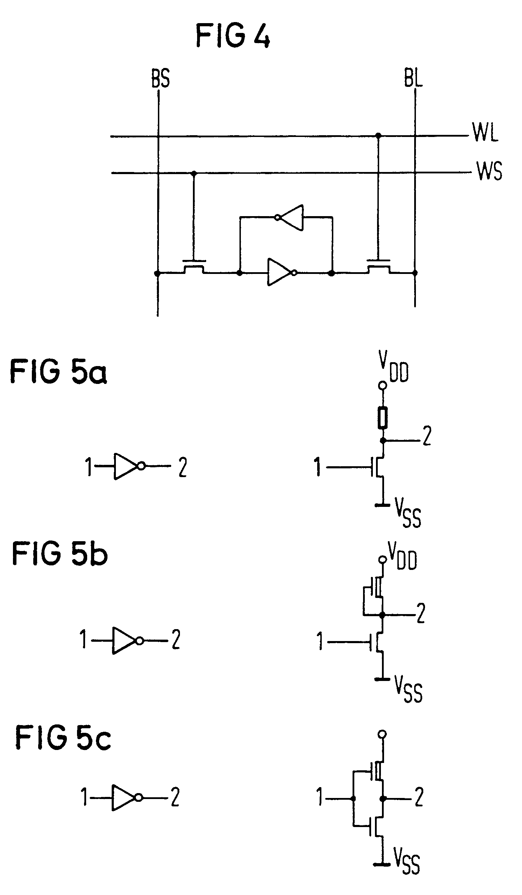

Fig. 5a, Fig. 5b und Fig. 5c zeigen, wie bereits eingangs erläutert, verschiedene Ausführungsformen der invertierenden Verstärker, wie sie gemäß Fig. 4 als Kippglieder in Antiparallelschaltung paarweise angeordnet sind.

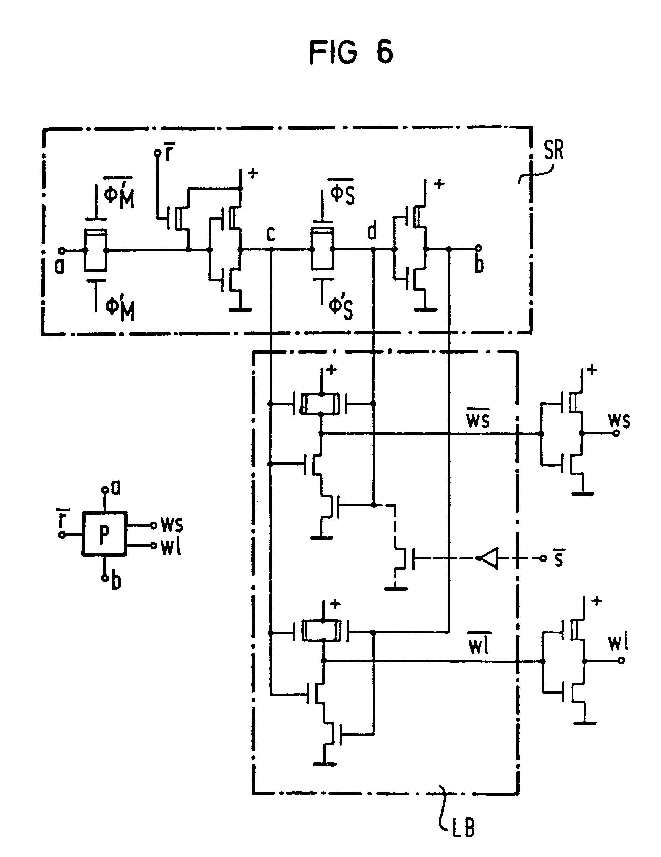

Fig. 6 zeigt, wie bereits erläutert, die Darstellung einer Zeilenwählerstufe P. In einem Schieberegisterblock SR sind zwei dynamische Registerstufen, die durch mittels Hilfstakten $ø'_M$, $\overline{ø'_M}$ ; $ø_S$, $\overline{ø_S}$ gesteuerte Schalter voneinander bzw. vom den Signaleingang a trennbar sind, vorgesehen. Die Hilfstakte $ø'_M$ und $\overline{ø'_M}$ entsprechen den Hilftakten $ø_M$ und $\overline{ø_M}$ gemäß Fig. 2. Sie stellen allerdings Ergebnissignale einer Verknüpfung der betreffenden in Fig. 2 gezeigten Signale mit dem Reset-Signal dar. Diese Verknüpfung bewirkt ein Schließen des Schalters am Eingang des Schieberegisterblocks SR für die Dauer des Reset-Signals. In einem Logikblock LB sind zwei Verknüpfungsglieder vorgesehen, die die an den Punkten c, d, b auftretenden Signale nach foldenden Funktionen miteinander verknüpfen :

$$\overline{ws} = \overline{c \wedge d}$$

EP 0 217 122 B1

$$\overline{wl} = \overline{c \wedge b}$$

Die Ausgangssignale $\overline{ws}$ und $\overline{wl}$ des Logik-Blocks LB werden mittels invertierender Treiber auf die Schreibwortleitung ws bzw. die Lesewortleitung der zugehörigen Zeile der matrixförmigen Speicheranordnung geschaltet. Es ist für die Stufen $P_2...P_n$ des Zeilenwählers gemäß Fig. 1 jeweils ein Reset-Eingang $\overline{r}$ vorgesehen. An dessen Stelle tritt bei der Stufe $P_1$ ein Setzeingang $\overline{s}$, wie dies in Fig. 6 gestrichelt angedeutet ist.

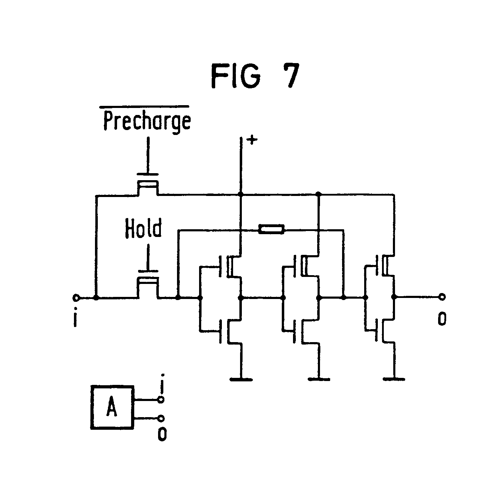

Fig. 7 zeigt schließlich, wie bereits erläutert, eine Darstellung eines Regenerators. Die Aufgabe dieses Regenerators besteht darin, das auf der seinem Eingang i zugeordneten Lesebitleitung bl auftretende geschwächte Lesesignal auf den Normalpegel zu verstärken und dieses auf die seinem Ausgang o zugeordnete, kapazitiv stark belastete Schreibbitleitung bs auszugeben. Die Schaltung dieses Regenerators enthält eine dreistufige Inverteranordnung mit einem darin enthaltenen Mitkopplungspfad. Der Inverteranordnung ist ein Schalter vorgeordnet, der jedesmal dann, wenn die Lesebitleitung für den nächsten Taktzyklus vorgeladen wird – gesteuert von dem Hold-Signal – die Inverteranordnung von dem Eingang i abtrennt und dadurch die eingespeicherte Information festhält. Dabei wird das Vorladen von einem durch das $\overline{\text{Precharge}}$-Signal gesteuerten weiteren Schalter bewirkt.

## Bezugszeichenliste

| | |
|---|---|
| $\phi$ | Takteingang / Grundtakt |
| $\phi_P$ | Taktsteuerung |
| a | Signaleingang |
| b | Signalausgang |
| $\overline{s}$ | Setzeingang |
| $\overline{r}$ | Rücksetzeingang |
| ws | Schreibwortleitung |
| wl | Lesewortleitung |
| $P_1 \ldots P_n$ | Stufe / Zeilenwähler |
| $S_{11} \ldots S_{nm}$ | Speicherzelle |
| $A_1 \ldots A_m$ | Verstärker |
| $Z_0 \ldots Z_m$ | Datenausgang |
| bl | Lesebitleitung |
| $\phi_M$ | Hilfstakt |
| $\phi_S$ | Hilfstakt |
| SP | Speicheranordnung |
| $D_i$ | Dateneingang |
| EST | Einstell- und Steuereinrichtung |
| Z | Zähler |
| G1 | UND-Glied |
| G2 | ODER-Glied |
| G3 | NOR-Glied |
| C1 | erster Komparator |
| C2 | zweiter Komparator |
| K1 | Vergleichsausgang |
| K2 | Vergleichsausgang |
| RESET | Rücksetzeingang |
| R | Rücksetzeingang |

$Q_S$
$Q_{N+1}$
$Q_N$   Datenausgang
$Q_2$
$Q_1$

$V_S$

$V_{N-1}$

$V_N$          Einstelleingang

$V_2$

$V_1$

AUS          Auswahleinrichtung

$D_1$          erster Multiplexer

$D_2$          zweiter Multiplexer

$D_3$          dritter Multiplexer

$E_1$

$E_2$

$E_3$          Dateneingang

$E_{M-1}$

$E_M$

A          Ausgang

$ST_1$          Wahleingang

$ST_M$          Wahleingang

$D_0$          Datenausgang

SR          Schieberegisterblock

$\phi'_M$

$\overline{\phi'_M}$

$\phi_S$          Hilfstakt

$\phi'_S$

a

b

c          Punkt

d

LB          Logikblock

i          Eingang

o          Ausgang

**Ansprüche**

1. Schaltungsanordnung mit einer matrixförmigen Speicheranordnung zur variabel einstellbaren Verzögerung digitaler Signale,
wobei ein von einem Eingangsdatentakt taktgesteuerter, kontinuierlich fortschaltbarer Zeilenwähler ($P_1...P_n$) vorgesehen ist, der je zwei in der Phase gegeneinander versetzte Signalausgänge je Wählschritt aufweist, die jeweils eine von Schreibwortleitungen ($w_s$) bzw. von Lesewortleitungen ($w_1$) ansteuern, welche je Zeile der Matrix vorgesehen sind,
wobei je Spalte zwei getrennte Bitleitungen, nämlich eine von Schreibbitleitungen ($b_s$) und eine von Lesebitleitungen ($b_1$), vorgesehen sind, die jeweils mit allen Speicherzellen einer Spalte zusammengeschaltet sind,
wobei je Spalte ein abtrennbarer, speichernder Verstärker ($A_1...A_m$) vorgesehen ist, dessen Eingang (i) mit der Lesebitleitung ($b_1$) der ihm zugeordneten Spalte und dessen Ausgang (o) mit der Schreibbitleitung ($b_s$) der ihm nachgeordneten Spalte verbunden ist, und
wobei die Speicheranordnung (SP) einen Dateneingang ($D_l$) aufweist, über den die zu verzögernden Datensignale eingebbar sind, **dadurch gekennzeichnet,**
- daß als speichernde Elemente Kippglieder in Form von zwei miteinander rückgekoppelten Invertern vorgesehen sind, von deren zwei Knoten der eine über einen von einer Schreibwortleitung ($w_s$) her steuerbaren Schalttransistor mit einer Schreibbitleitung ($b_s$) und der andere über einen von einer Lesewortleitung ($w_1$) her steuerbaren Schalttransistor mit einer Lesebitleitung ($b_1$) verbindbar ist,
- daß der Zeilenwähler ($P_1...P_n$) jederzeit rücksetzbar ist,
- daß der Ausgang (o) jedes der Verstärker ($A_1...A_m$) jeweils als ein ihm zugeordneter Datenausgang ($Z_1...Z_m$) dient,
- daß der Dateneingang für die zu verzögernden Datensignale mit der Schreibbitleitung ($b_s$) der ersten Spalte verbunden ist,
- daß ein Rücksetzeingang ($\overline{Reset}$) mit Setzeingängen (a, $\overline{s}$) eines ersten Gliedes ($P_1$) des Zeilenwählers sowie mit den Rücksetzeingängen ($\overline{r}$) der restlichen Glieder ($P_2...P_n$) des Zeilenwählers verbunden ist,
- daß eine Auswahleinrichtung (AUS) zum Auswählen von Spalten der Speicheranordnung (SP) vorgesehen ist, die zwischen zwei ausgewählten benachbarten Spalten umschaltbar ist und der ein Teil eines externen Verzögerungzeit-Einstelldatenwortes zur Auswahl dieser Spalten zuführbar ist,
- daß zum Umschalten zwischen den beiden benachbarten Spalten eine dynamische Umschaltung mittels eines zugeführten Steuergsignals (ST) vorgesehen ist,
- daß eine Einstell- und Steuereinrichtung (EST) vorgesehen ist, der das gesamte externe Versögerungszeit-Einstelldatenwort zugeführt wird, die ein Rückstellsignal ($\overline{RESET}$) für die Speicheranordnung (SP) und das Steuersignal (ST) für die Auswahleinrichtung (AUS) erzeugt und der ein externes Rücksetzsignal (RESET) über einen Rücksetzeingang zugeführt wird, welches dazu benutzt wird, die Einstell- und Steuereinrichtung (EST) unmittelbar und die Speicheranordnung (SP) mittelbar rückzustellen,
- daß die Auswahleinrichtung (AUS) einen Datenausgang ($D_o$) aufweist, über den die verzögerten Datensignale ausgebbar sind,
- daß die Auswahleinrichtung (AUS) mit Dateneingängen ($E_1...E_M$) mit Datenausgängen ($Z_1...Z_M$) der Speicheranordnung (SP) verbunden ist und
- daß die Einstell- und Steuereinrichtung (EST) datentaktgesteuert ist.

2. Schaltungsanordnung nach Anspruch 1, dadurch **gekennzeichnet,**
- daß die Auswahleinrichtung (AUS) aus einer Anordnung aus einem ersten Multiplexer ($D_1$), einem zweiten Multiplexer ($D_2$) und einem dritten Multiplexer ($D_3$) besteht, wobei Datenausgänge ($Z_1...Z_M$) der Speicheranordnung (SP) jeweils mit Dateneingängen ($E_1...E_M$) des ersten Multiplexers ($D_1$) und mit Dateneingängen ($E_2...E_M$) des zweiten Multiplexers ($D_2$) unter Versatz um eine Stelle verbunden sind, wobei der letzte Datenausgang ($Z_M$) der Speicheranordnung (SP) nicht mit einem der Dateneingänge des zweiten Multiplexers ($D_2$) verbunden ist und wobei der erste Dateneingang ($E_1$) dieses zweiten Multiplexers ($D_2$) frei bleibt,
- daß für beide Multiplexer ($D_1$, $D_2$) jeweils Wähleingänge ($ST_1...ST_M$) vorgesehen sind, die mit dem genannten Teil des externen Verzögerungzeit-Einstelldatenwortes beaufschlaft werden und mittels derer in den Multiplexern ($D_1$, $D_2$) jeweils deren Ausgang (A) mit einem der Dateneingänge (z.B. $E_2$) in dem ersten Multiplexer ($D_1$) bzw. ($E_2$) in dem zweiten Multiplexer ($D_2$) verbindbar ist,
- daß die beiden Ausgänge (A, A) der Multiplexer ($D_1$, $D_2$) mit den beiden einzigen Dateneingängen ($E_1$, $E_2$) des dritten Multiplexers ($D_3$) verbunden sind, dessen Ausgang (A) den Datenausgang ($D_o$) für die verzögerten Eingangsdaten darstellt und der einen einzigen Steuereingang (ST) aufweist,

9

– daß die Einstell- und Steuereinrichtung (EST) einen Zähler (Z), einen ersten Komparator (C₁), einen zweiten Komparator (C₂), ein UND-Glied (G₁), ein ODER-Glied (G₂) und ein NOR-Glied (G₃) enthält,

– daß der Zähler (Z) eine Anzahl von Zählschritten aufweist, die der Anzahl der Speicherplätze der Speicheranordnung (SP) entspricht,

– daß der erste Komparator (C₁) die Funktion "=" aufweist,

– daß der zweite Komparator (C₂) die Funktion "≤" aufweist,

– daß die Einstell- und Steuereinrichtung (EST) eine Vielzahl von Einstelleingängen (V₁, V₂...V_N, V_{n+1} ...V_S) zum Anlegen des externen Verzögerungszeit-Einstelldatenwortes und einen Rücksetzeingang (RESET) hat, wobei die Einstelleingänge in eine erste Gruppe für die niederwertigen Bits des Verzögerungszeit-Einstelldatenwortes mit den Einstelleingängen (V₁...V_N) und in eine zweite Gruppe für die höherwertigen Bits mit den Einstelleingängen (V_{N+1}...V_S) unterteilt sind,

– daß mittels der Einstelleingänge (V₁...V_N) der ersten Gruppe eine beliebige Zeile der Speicheranordnung (SP) in codierter Form gekennzeichnet wird, welche Kennzeichnung als ein erster Vergleichswert für den zweiten Komparator (C₂) dient, und mittels der Einstelleingänge sowohl der ersten als auch der zweiten Gruppe die betreffende Zeile bzw. eine beliebige Spalte in codierter Form gekennzeichnet wird, welche Kennzeichnungen insgesamt als ein erster Vergleichswert für den ersten Komparator (C₁) dienen,

– daß der erste Komparator (C₁) eine Vielzahl von Vergleichswerteingängen entsprechend Datenausgängen (Q₁... Q_N, Q_{N+1}...Q_S) des Zählers (Z) hat, denen ein dem jeweiligen Zählstand des Zählers (Z) entsprechendes Zählstandsdatenwort zugeführt wird,

– daß der zweite Komparator (C₂) eine Anzahl von Vergleichswerteingängen entsprechend den Datenausgängen (Q₁...Q_N) einer ersten Gruppe der Datenausgänge des Zählers (Z) hat, denen die niederwertigen Bits des dem jeweiligen Zählstand entsprechenden Zählstandsdatenwortes zugeführt werden,

– daß dem UND-Glied (G₁) gleichfalls diese zuletzt genannten Bits über entsprechend viele Eingänge zugeführt werden,

– daß der erste Komparator (C₁) einen Vergleichsausgang (K₁) hat, der mit einem von zwei Eingängen des ODER-Gliedes (G₂) und einem von zwei Eingängen des NOR-Gliedes (G₃) verbunden ist und ein Ausgangssignal gemäß der Bedingung

$$K_1 = \{Q_1...Q_S\} = \{V_1...V_S\}$$

abgibt,

– daß der zweite Eingang des ODER-Gliedes (G₂) mit dem Rücksetzeingang der Einstell- und Steuereinrichtung (EST) verbunden ist,

– daß der zweite Eingang des NOR-Gliedes (G₃) mit dem Ausgang des UND-Gliedes (G₁) verbunden ist,

– daß der Rücksetzeingang der Speicheranordnung (SP) mit dem Ausgangssignal des NOR-Gliedes (G₃) beaufschlagt wird,

– daß ein Rücksetzeingang (R) des Zählers (Z) mit dem Ausgangssignal des ODER-Gliedes (G₂) beaufschlagt wird,

– daß ein Vergleichsausgang (K₂) des zweiten Komparators (C₂) mit dem Steuereingang (ST) des dritten Multiplexers (D₃) verbunden ist und

– daß der zweite Komparator (C₂) ein Ausgangssignal an den Vergleichsausgang (K₂) gemäß der Bedingung

$$K_2 = \{Q_1...Q_N\} \le \{V_1...V_N\}$$

abgibt, in welchem Fall der erste Dateneingang (E₁) des dritten Multiplexers (D₃) mit dessen Datenausgang (D_o) verbunden ist.

3. Schaltungsanordnung nach Anspruch 1 oder 2, dadurch **gekennzeichnet**, daß entsprechend der Wortbreite der Eingangsdaten eine Vielzahl von matrixförmigen Speicheranordnungen vorgesehen sind, deren Schreibwort- bzw. Lesewortleitungen parallelgeschaltet und mit dem gemeinsam für diese matrixförmigen Speicheranordnungen vorgesehenen Zeilenwähler verbunden sind und daß für jede der matrixförmigen Speicheranordnungen eine Auswahleinrichtung vorgesehen ist, welche Auswahleinrichtungen mit der gemeinsam für diese Auswahleinrichtungen vorgesehenen Einstell- und Steuereinrichtung verbunden sind.

4. Schaltungsanordnung nach Anspruch 1 oder 2, dadurch **gekennzeichnet**, daß ein RESET-Signal, das dem Rücksetzeingang (RESET) zugeführt wird, mit den Eingangssignalen bereitgestellt wird.

5. Schaltungsanordnung nach Anspruch 1 oder 2, dadurch **gekennzeichnet**, daß ein RESET-Signal intern in dem die Schaltungsanordnung aufweisenden Chip durch einen von außen einstellbaren zyklischen Zähler erzeugt wird.

EP 0 217 122 B1

6. Schaltungsanordnung nach einem der vorhergehenden Ansprüche, dadurch **gekennzeichnet**, daß aus der Schaltungsanordnung nur diejenigen Datenausgänge herausgeführt sind, die für den jeweiligen Verwendungszweck der Schaltungsanordnung erforderlich sind.

7. Schaltungsanordnung nach einem der vorhergehenden Ansprüche, dadurch **gekennzeichnet**, daß die Verstärker ($A_1$...$A_m$) invertierend sind.

8. Schaltungsanordnung nach einem der Ansprüche 1 bis 6, dadurch **gekennzeichnet**, daß die Verstärker ($A_1$...$A_m$) nichtinvertierend sind und daß dementsprechend jeweils ein Inverter an jedem zweiten Datenausgang ($Z_1$...$Z_M$) angeordnet ist.

9. Schaltungsanordnung nach einem der vorhergehenden Ansprüche, dadurch **gekennzeichnet**, daß sie als monolithisch integrierte MOS-Schaltung realisiert ist.

10. Schaltungsanordnung nach Anspruch 1, dadurch **gekennzeichnet**, daß der Zeilenwähler ($P_1$...$P_n$) jeweils aus einem Schieberegister, einem Verknüpfungsblock und zwei Ausgangstreibern mit Ausgängen (ws bzw. wl) je Glied des Zeilenwählers besteht und daß die Phasenlagen und Impulsbreiten der Ausgangssignale an den Ausgängen (ws und wl) durch entsprechende Verknüpfungen dreier in dem Schieberegister vorhandener Abgriffe bewirkt werden.


**Claims**

1. Circuit arrangement with a memory arranged in a matrix form for variably setting the delay of digital signals,
in which a continuously steppable row selector ($P_1$...$P_n$) clock-controlled by an input data clock is provided, which has in each case two mutually phase-offset signal outputs per selection step which address in each case one of the write word lines ($w_s$) or of the read word lines ($w_1$) provided per row of the matrix,
in which two separate bit lines, namely one of the write bit lines ($b_s$) and one of the read bit lines ($b_1$) are provided per column which are interconnected in each case to all memory cells of a column,
in which a disconnectable storage amplifier ($A_1$...$A_m$) is provided per column, the input (i) of which is connected to the read bit line ($b_1$) of the column assigned thereto and the output (o) of which is connected to the write bit line ($b_s$) of the column following thereafter, and
in which the memory arrangement (SP) has a data input ($D_i$) via which the data signals to be delayed can be entered,
characterised
– in that trigger circuits in the form of two inverters fed back to one another are provided as storage elements, one of the two nodes of which can be connected to a write bit line ($b_s$) via a switching transistor which can be controlled by a write word line ($w_s$), and the other of which can be connected to a read bit line ($b_1$) via a switching transistor which can be controlled from a read word line ($w_1$),
– in that the row selector ($P_1$...$P_n$) can be reset at any time,
– in that the output (o) of each of the amplifiers ($A_1$...$A_m$) serves in each case as a data output ($Z_1$...$Z_m$) assigned thereto,
– in that the data input for the data signals to be delayed is connected to the write bit line ($b_s$) of the first column,
– in that a reset input ($\overline{\text{Reset}}$) is connected to set inputs (a, $\bar{s}$) of a first element ($P_1$) of the row selector as well as to the reset inputs ($\bar{r}$) of the remaining elements ($P_2$...$P_n$) of the row selector,
– in that a selection device (AUS) for selecting columns of the memory arrangement (SP) is provided, which can be switched over between two selected neighbouring columns and which can be supplied with a part of an external delay time setting data word for selecting these columns,
– in that a dynamic switchover by means of a supplied control signal (ST) is provided for switching over between the two neighbouring columns,
– in that a setting and control device (EST) is provided, to which the entire external delay time setting data word is supplied, which generates a reset signal ($\overline{\text{RESET}}$) for the memory arrangement (SP) and the control signal (ST) for the selection device (AUS), and to which an external reset signal (RESET) is supplied via a reset input, which is used for directly resetting the setting and control device (EST) and indirectly resetting the memory arrangement (SP),
– in that the selection device (AUS) has a data output ($D_o$), via which the delayed data signals can be output,
– in that, with data inputs ($E_1$...$E_M$), the selection device (AUS) is connected to data outputs ($Z_1$...$Z_M$) of the memory arrangement (SP), and
– in that the setting and control device (EST) is data-clock-controlled.

2. Circuit arrangement according to Claim 1,

11

characterised

– in that the selection device (AUS) comprises an arrangement of a first multiplexer ($D_1$), a second multiplexer ($D_2$) and a third multiplexer ($D_3$), data outputs ($Z_1...Z_M$) of the memory arrangement (SP) being connected in each case to data inputs ($E_1...E_M$) of the first multiplexer ($D_1$) and to data inputs ($E_2...E_M$) of the second multiplexer ($D_2$) offset by one position, the last data output ($Z_M$) of the memory arrangement (SP) not being connected to one of the data inputs of the second multiplexer ($D_2$), and the first data input ($E_1$) of said second multiplexer ($D_2$) remaining free,

– in that there are provided in each case for both multiplexers ($D_1$, $D_2$) selection inputs ($ST_1...ST_M$) which receive the abovementioned part of the external delay the setting data word, and by means of which, in the multiplexers ($D_1$, $D_2$), in each case their output (A) can be connected to one of the data inputs (e.g. $E_2$) in the first multiplexer ($D_1$) or ($E_2$) in the second multiplexer ($D_2$),

– in that the two outputs (A, A) of the multiplexers ($D_1$, $D_2$) are connected to the two single data inputs ($E_1$, $E_2$) of the third multiplexer ($D_3$), whose output (A) represents the data output ($D_o$) for the delayed input data and which has a single control input (ST),

– in that the setting and control device (EST) contains a counter (Z), a first comparator ($C_1$), a second comparator ($C_2$), an AND gate ($G_1$), an OR gate ($G_2$) and a NOR gate ($G_3$),

– in that the counter (Z) has a number of counting stages corresponding to the number of memory locations of the memory arrangement (SP),

– in that the first comparator ($C_1$) has the function "=",

– in that the second comparator ($C_2$) has the function "$\leq$",

– in that the setting and control device (EST) has a plurality of setting inputs ($V_1$, $V_2...V_N$, $V_{n+1}...V_S$) for applying the external delay time setting data word and a reset input (RESET), the setting inputs being divided into a first group for the lower order bits of the delay time setting data word with the setting inputs ($V_1...V_N$) and into a second group for the higher order bits with the setting inputs ($V_{N+1}...V_S$),

– in that, by means of the setting inputs ($V_1...V_N$) of the first group, any row of the memory arrangement (SP) is identified in coded form, which coding serves as a first reference value for the second comparator ($C_2$) and, by means of the setting inputs both of the first and of the second group, the respective row or any column is identified in coded form, which codings serve in toto as a first reference value for the first comparator ($C_1$),

– in that the first comparator ($C_1$) has a plurality of data outputs ($Q_1...Q_N$, $Q_{N+1}...Q_S$), corresponding to reference value inputs, of the counter (Z), to which a counter reading data word corresponding to the respective counter reading of the counter (Z) is supplied,

– in that the second comparator ($C_2$) has a number of reference value inputs corresponding to the data outputs ($Q_1...Q_N$) of a first group of the data outputs of the counter (Z), to which the lower-order bits of the counter reading data word corresponding to the respective counter reading are supplied,

– in that these aforementioned bits are likewise supplied to the AND gate ($G_1$) via a corresponding number of inputs,

– in that the first comparator ($C_1$) has a reference output ($K_1$) which is connected to one of two inputs of the OR gate ($G_2$) and one of two inputs of the NOR gate ($G_3$) and outputs an output signal in accordance with the relationship

$$K_1 = \{Q_1...Q_S\} = \{V_1...V_S\},$$

– in that the second input of the OR gate ($G_2$) is connected to the reset input of the setting and control device (EST),

– in that the second input of the NOR gate ($G_3$) is connected to the output of the AND gate ($G_1$),

– in that the reset input of the memory arrangement (SP) receives the output signal of the NOR gate ($G_3$),

– in that a reset input (R) of the counter (Z) receives the output signal of the OR gate ($G_2$),

– in that a reference output ($K_2$) of the second comparator ($C_2$) is connected to the control input (ST) of the third multiplexer ($D_3$), and

– in that the second comparator ($C_2$) outputs an output signal to the reference output ($K_2$) in accordance with the relationship

$$K_2 = \{Q_1...Q_N\} \leq \{V_1...V_N\},$$

in which case the first data input ($E_1$) of the third multiplexer ($D_3$) is connected to the data output ($D_o$) thereof.

3. Circuit arrangement according to Claim 1 or 2, characterised in that, in accordance with the word width of the input data, a plurality of memories arranged in a matrix form are provided, the write word and read word lines of which are connected in parallel and are connected to the row selector provided in common for these memories arranged in matrix form, and in that a selection device is provided for each of the memories arranged in matrix form, which selection devices are connected to the setting and control device provided in common for said selection devices.

4. Circuit arrangement according to Claim 1 or 2, characterised in that a RESET signal, which is supplied to the reset input (RESET), is made available with the input signals.

5. Circuit arrangement according to Claim 1 or 2, characterised in that a RESET signal is generated internally in the chip having the circuit arrangement by a cyclical counter which can be set from outside.

6. Circuit arrangement according to one of the preceding claims, characterised in that only the data outputs which are required for the respective purpose of the circuit arrangement are lead out of the circuit arrangement.

7. Circuit arrangement according to one of the preceding claims, characterised in that the amplifiers $(A_1...A_m)$ are inverting.

8. Circuit arrangement according to one of Claims 1 to 6, characterised in that the amplifiers $(A_1...A_m)$ are non-inverting, and in that accordingly one inverter is arranged in each case at each second data output $(Z_1...Z_M)$.

9. Circuit arrangement according to one of the preceding claims, characterised in that it is realised as a monolithically integrated MOS circuit.

10. Circuit arrangement according to Claim 1, characterised in that the row selector $(P_1...P_n)$ comprises in each case a shift register, a logic block and two output drivers with outputs (ws and wl) for each element of the row selector, and in that the phase relationships and pulse widths of the output signals are effected at the outputs (ws and wl) by corresponding gating of three taps present in the shift register.


## Revendications

1. Montage comportant un dispositif de mémoire en forme de matrice pour retarder des signaux numériques d'une manière réglable de façon variable, et dans lequel il est prévu un compteur de lignes $(P_1...P_n)$, qui est commandé de façon cadencée par une cadence de données d'entrée, peut avancer d'une manière continue et comporte, pour chaque pas de sélection, respectivement deux sorties des signaux, qui délivrent des signaux présentant un décalage de phase réciproque et commandent respectivement l'un de conducteurs de transmission de mots d'enregistrement $(w_s)$ et l'un de conducteurs de transmission de mots de lecture $(w_1)$, qui sont prévus pour chaque ligne de la matrice,

pour chaque colonne, il est prévu deux conducteurs séparés de transmission de bits, à savoir l'un de conducteurs de transmission de bits d'enregistrement $(b_s)$ et l'un de conducteurs de transmission de bits de lecture $(b_1)$, qui sont interconnectés respectivement à toutes les cellules de mémoire d'une colonne,

pour chaque colonne, il est prévu un amplificateur de mémorisation $(A_1...A_m)$, qui peut être déconnecté et dont l'entrée (i) est raccordée au conducteur de transmission de bits de lecture $(b_1)$ de la colonne qui lui est associée, et dont la sortie (o) est raccordée au conducteur de transmission de bits d'enregistrement $(b_s)$ de la colonne qui est disposée en aval de cette borne,

dispositif de mémoire (SP) possédant une entrée de données $(D_i)$, au moyen de laquelle les signaux de données devant être retardés peuvent être introduits,

caractérisé par le fait

– qu'il est prévu, comme éléments exécutant la mémorisation, des circuits à bascule se présentant sous la forme d'inverseurs couplés entre eux par réaction, parmi deux noeuds dequels l'un est raccordé à un conducteur de transmission de bits d'enregistrement $(b_s)$ par l'intermédiaire d'un transistor de commutation pouvant être commandé par un conducteur de transmission de mots d'enregistrement $(w_s)$, et l'autre peut être raccordé à un conducteur de transmission de bits de lecture $(b_1)$, par l'intermédiaire d'un transistor de commutation pouvant être commandé à partir d'un conducteur de transmission de mots de lecture $(w_1)$,

– que le sélecteur de lignes $(P_1...P_n)$ peut être ramené à tout moment à l'état initial,

– que la sortie (o) de chacun des amplificateurs $(A_1...A_m)$ est utilisée respectivement en tant que sortie de données $(Z_1... Z_m)$, qui lui est associée,

– que l'entrée de données pour les signaux de données, qui doivent être retardés, est raccordée au conducteur de transmission de bits d'enregistrement $(b_s)$ de la première colonne,

– qu'une entrée de remise à l'état initial ($\overline{Reset}$) est raccordée à des entrées de positionnement $(a, \bar{s})$ d'un premier circuit $(P_1)$ du sélecteur de lignes, ainsi qu'aux entrées de remise à l'état initial $(\bar{r})$ des autres circuits $(P_2...P_n)$ du sélecteur de ligne,

– qu'il est prévu un dispositif de sélection (AUS) servant à réaliser une sélection de colonnes du dispositif de mémoire (SP) et qui peut être commuté entre deux colonnes sélectionnées voisines et auquel peut être envoyée une partie d'un mot externe de données de réglage du retard, pour la sélection de ces colonnes,

13

– que pour la commutation entre les deux colonnes voisines, il est prévu une commutation dynamique réalisée au moyen de l'envoi d'un signal de commande (ST),

– qu'il est prévu un dispositif de réglage et de commande (EST), auquel est envoyé le mot externe complet de données de réglage du retard et qui produit un signal de remise à l'état initial ($\overline{RESET}$) pour le dispositif de mémoire (SP) et le signal de commande (ST) pour le dispositif de sélection (AUS) et auquel est envoyé, par l'intermédiaire d'une entrée de remise à l'état initial, un signal externe de remise à l'état initial (RESET), qui est utilisé pour ramener directement à l'état initial le dispositif de réglage et de commande (EST) et ramener indirectement à l'état initial le dispositif de mémoire (SP),

– que le dispositif de sélection (AUS) possède une sortie de données ($D_o$), au moyen de laquelle les signaux de données retardés peuvent être délivrés,

– que des entrées de données ($E_1...E_M$) du dispositif de sélection (AUS) sont raccordées à des sorties de données ($Z_1...Z_M$) du dispositif de mémoire (SP), et

– que le dispositif de réglage et de commande (EST) est commandé par la cadence des données.

2. Montage suivant la revendication 1, caractérisé par le fait

– que le dispositif de sélection (AUS) est constitué par un agencement formé d'un premier multiplexeur ($D_1$), d'un second multiplexeur ($D_2$) et d'un troisième multiplexeur ($D_3$), des sorties de données ($Z_1...Z_M$) du dispositif de mémoire (SP) étant raccordées respectivement à des entrées de données ($E_1...E_M$) du premier multiplexeur ($D_1$) et à des entrées de données ($E_2...E_M$) du second multiplexeur ($D_2$) moyennant un décalage d'une position, alors que la dernière sortie de données ($Z_M$) du dispositif de mémoire (SP) n'est pas raccordée à l'une des entrées de données du second multiplexeur ($D_2$) et que la première entrée de données ($E_1$) de ce second multiplexeur ($D_2$) reste libre,

– que pour les deux multiplexeurs ($D_1$, $D_2$), il est prévu respectivement des entrées de sélection ($ST_1...ST_M$), qui sont chargées par ladite partie du mot externe de réglage du retard et à l'aide desquelles respectivement la sortie (A) des multiplexeurs ($D_1$, $D_2$) peut être raccordée à l'une des entrées de données (par exemple $E_2$) situées dans le multiplexeur ($D_1$) ou ($E_2$) dans le second multiplexeur ($D_2$),

– que les deux sorties (A, A) des multiplexeurs ($D_1$, $D_2$) sont reliées aux deux entrées uniques de données ($E_1$, $E_2$) du troisième multiplexeur ($D_3$), dont la sortie (A) représente la sortie de données ($D_o$) pour les données d'entrée retardées et qui possède une seule entrée de commande (ST),

– que le dispositif de réglage et de commande (EST) contient un compteur (Z), un premier comparateur ($C_1$), un second comparateur ($C_2$), un circuit ET ($G_1$), un circuit OU ($G_2$) et un circuit NON-OU ($G_3$),

– que le compteur (Z) possède un nombre de pas de comptage, qui correspond au nombre des emplacements de mémoire du dispositif de mémoire (SP),

– que le premier comparateur ($C_1$) possède la fonction "=",

– que le second comparateur ($C_2$) possède la fonction "≤",

– que le dispositif de réglage et de commande (EST) possède une multiplicité d'entrées de réglage ($V_1$, $V_2...V_N$, $V_{n+1}...V_S$) servant à appliquer le mot externe de données de réglage du retard, et une entrée de remise à l'état initial (RESET), les entrées de réglage étant réparties en un premier groupe pour les bits de poids inférieur du mot de données de réglage du retard avec les entrées de réglage ($V_1...V_N$) et en un second groupe pour les bits de poids supérieur avec les entrées de réglage ($V_{N+1}...V_S$),

– qu'à l'aide des entrées de réglage ($V_1...V_N$) du premier groupe, une ligne quelconque du dispositif de mémoire (SP) est caractérisée sous forme codée, cette caractérisation étant utilisée en tant que première valeur de référence pour un second comparateur ($C_2$), et qu'au moyen des entrées de réglage aussi bien du premier que du second groupe, la ligne considérée ou une colonne quelconque est caractérisée sous forme codée, ces caractérisations étant utilisées globalement en tant que premières valeurs de référence pour le premier comparateur ($C_1$),

– que le premier comparateur ($C_1$) possède une multiplicité d'entrées de valeurs de référence correspondant aux sorties de données ($Q_1...Q_N$, $Q_{N+1}...Q_S$) du compteur (Z), auxquelles est envoyé un mot de données d'état de comptage correspondant à l'état de comptage respectif du compteur (Z),

– que le second comparateur ($C_2$) possède un nombre d'entrées de valeurs de référence qui correspond aux sorties de données ($Q_1...Q_N$) d'un premier groupe de sorties de données du compteur (Z), auxquelles sont envoyés des bits de poids inférieur du mot de données d'état de comptage qui correspond à l'état de comptage respectif,

– que ces bits indiqués en dernier lieu sont également envoyés au circuit ET ($G_1$) par l'intermédiaire d'un nombre d'entrées correspondantes,

– que le premier comparateur ($C_1$) possède une entrée de référence ($K_1$), qui est raccordé à l'une de deux entrées du circuit OU ($G_2$) et à l'une des deux entrées du circuit NON-OU ($G_3$) et délivre un signal de sortie correspondant à la condition

$$K_1 = \{Q_1...Q_S\} = \{V_1...V_S\},$$

– que la seconde entrée du circuit OU ($G_2$) est raccordée à l'entrée de remise à l'état initial du dispositif de réglage et de commande (EST),

– que la seconde entrée du circuit NON-OU ($G_3$) est raccordée à la sortie du circuit ET ($G_1$),

– que l'entrée de remise à l'état initial du dispositif de mémoire (SP) est chargée par le signal de sortie du circuit NON-ET (G3),

– que l'entrée de remise à l'état initial (R) du compteur (Z) est chargée par le signal de sortie du circuit OU ($G_2$),

– qu'une sortie de référence ($K_2$) du second comparateur ($C_2$) est raccordée à l'entrée de commande (ST) du troisième multiplexeur ($D_3$),

– que le second comparateur ($C_2$) délivre à la sortie de référence ($K_2$) un signal de sortie correspondant à la condition

$$K_2 = \{Q_1...Q_N\} \le \{V_1...V_N\}$$

auquel cas la première entrée de données ($E_1$) du troisième multiplexeur ($D_3$) est raccordée à la sortie de données ($D_o$) de ce multiplexeur.

3. Montage suivant la revendication 1 ou 2, caractérisé par le fait qu'il est prévu, en fonction de la largeur de mots des données d'entrée, une multiplicité de dispositifs de mémoire en forme de matrices dont les conducteurs de transmission de mots d'enregistrement et les conducteurs de transmission de mots de lecture sont transmis en parallèle et sont raccordés au sélecteur de lignes prévu en commun pour ces dispositifs de mémoire en forme de matrices et que pour chacun des dispositifs de mémoire en forme de matrices, il est prévu un dispositif de sélection, ces dispositifs de sélection étant raccordés au dispositif commun de réglage et de commande prévu pour ces dispositifs de sélection.

4. Montage suivant la revendication 1 ou 2, caractérisé par le fait qu'un signal RESET qui est envoyé à l'entrée de remise à l'état initial (RESET), est préparé au moyen des signaux d'entrée.

5. Montage suivant la revendication 1 ou 2, caractérisé par le fait qu'un signal RESET est produit de façon interne dans la microplaquette comportant le montage, au moyen d'un compteur cyclique réglable de l'extérieur.

6. Montage suivant l'une des revendications précédentes, caractérisé par le fait que seules les sorties de données, qui sont nécessaires pour le but respectif d'utilisation du montage, sont ressorties à partir de ce montage.

7. Montage suivant l'une des revendications précédentes, caracterisé par le fait que les amplificateurs ($A_1...A_m$) sont inversants.

8. Montage suivant l'une des revendications 1 à 6, caractérisé par le fait que les amplificateurs ($A_1...A_m$) sont non inverseurs et que par conséquent un inverseur est raccordé respectivement à chaque seconde entrée de données ($Z_1...Z_M$).

9. Montage suivant l'une des revendications précédentes, caractérisé par le fait qu'il est réalisé sous la forme d'un circuit MOS intégré monolithique.

10. Montage suivant la revendication 1, caractérisé par le fait que le sélecteur de lignes ($P_1...P_n$) est constitué respectivement par un registre à décalage, un bloc combinatoire et deux étages d'attaque de sortie comportant des sorties (ws et wl) pour chaque circuit du sélecteur de lignes, et que les positions de phase et les largeurs d'impulsions des signaux de sortie présents sur les sorties (ws et w1) sont obtenues au moyen de combinaisons correspondantes de trois prises présentes dans le registre à décalage.

# FIG 1

FIG 2

A   φ

B   φM

C   $\overline{\phi M}$

D   φS

E   $\overline{\phi S}$

F   Daten ein

G   wl

H   ws

I   Precharge

J   Hold

K   Reset

# FIG 3

VERZÖGERUNGSZEIT-
EINSTELLDATENENWORT

# FIG 4

BS                                    BL

WL

WS

# FIG 5a

$1 \!\!-\!\!\rhd\!\!\circ\!\!- 2$

$V_{DD}$

2

1

$V_{SS}$

# FIG 5b

$1 \!\!-\!\!\rhd\!\!\circ\!\!- 2$

$V_{DD}$

2

1

$V_{SS}$

# FIG 5c

$1 \!\!-\!\!\rhd\!\!\circ\!\!- 2$

1                    2

$V_{SS}$

# FIG 6

# FIG 7